# EUROPEAN PATENT SPECIFICATION

(11) **EP 4 457 908 B1**
(45) Date of publication and mention of the grant of the patent: **01.10.2025**
(21) Application number: 22840772.2
(22) Date of filing: 23.12.2022
(51) Int. Cl.: H01S 5/14, G02B 6/12, H01S 3/105, H01S 3/08, G02F 1/225, G02B 6/293, H01S 5/10, H01S 5/026, H01S 3/107, H01S 3/106, H01S 3/067, H01S 5/50, G02F 1/21

(54) **TUNABLE LASER**
ABSTIMMBARER LASER
LASER ACCORDABLE

(30) Priority: 31.12.2021 GB 202119136
(43) Date of publication of application: 06.11.2024
(73) Proprietor: SMART Photonics Holding B.V., 5656 AE Eindhoven (NL)
(72) Inventor: ANDREOU, Stefanos, 5656 AE Eindhoven (NL)
(74) Representative: EIP
(86) International application number: PCT/EP2022/087767
(87) International publication number: WO 2023/126359

(56) References cited:
- EP-A1- 2 597 736
- WO-A1-2014/021781
- US-A1- 2019 027 898
- LIU WEILIN ET AL: "An integrated parity-time symmetric wavelength-tunable single-mode microring laser", NATURE COMMUNICATIONS, vol. 8, no. 1, 12 May 2017 (2017-05-12), pages 1 - 6, XP093038558, DOI: 10.1038/ncomms15389

## Description

### Background

Tunable lasers are used to produce light of at least one of tunable wavelength or tunable irradiance. This allows the output of light with tuned wavelength and/or irradiance, for example for communications systems and optical systems. Efficient output of light and efficient and broad tuning of the output light can allow more accurate and/or faster optical devices. It is desirable to provide an improved laser. WO2014/021781A1 relates to an optical light source and optical transmitter; EP2597736A1 relates to a hybrid laser; US2019/027898A1 relates to a single-pass ring-modulated laser; and Liu Weilin et al. Nature Comms., vol. 8, no. 1, relates to an integrated parity-time symmetric wavelength-tunable single-mode microring laser.

### Brief Description of the Drawings

Figures 1 to 7 show schematically a plan views of tunable lasers in accordance with examples.
Figure 8 shows schematically a plan view of a photonic integrated circuit (PIC) in accordance with examples.
Figure 9 shows schematically a plan view of a device in accordance with examples.
Figure 10 schematically illustrates a method of manufacturing in accordance with examples.

### Detailed Description

The invention is defined in the appending independent claims. Preferred embodiments are disclosed in the dependent claims.

In examples to be described, not all of which being part of the invention as claimed, a linear tunable laser is configured such that an optical amplifier amplifies light and a tuning element, e.g. tunable resonator or interferometer, tunes at least one of the irradiance or the wavelength of the light output by the tunable laser. In so doing, the tunable laser can e.g. provide light of a chosen wavelength and/or irradiance.

Examples described herein relate to a linear tunable laser. A linear tunable laser comprises a linear optical cavity. In the invention according to the claims, both the wavelength and intensity of the output light from the linear tunable laser is tunable. In some examples, the linear tunable laser is a component of a semiconductor structure, e.g. a photonic integrated circuit (PIC). The output of light from the linear tunable laser is, for example, for light emitting devices or systems such as those for medical imaging, spectroscopy, telecommunications, optical data transmission and light detection and ranging (LIDAR).

For some examples described herein, the output light of the linear tunable laser has a single wavelength intensity-peak that is tunable over a range of, e.g. more than 35 nanometres. In some examples, a single intensity-peak is achieved by the superposition of three optical filters: the first tunable resonator, the second tunable resonator and the interferometer. In other examples, a single intensity-peak is achieved by the superposition of four optical filters: the first tunable resonator, the second tunable resonator, the first interferometer and the second interferometer. In further examples, the single intensity-peak and wavelength tuning are achieved by the superposition of two optical filters: the first tunable resonator and the interferometer, and tuning of the irradiance of the output light is achieved by the second tunable resonator. In the invention according to the claims, the single intensity-peak and wavelength tuning are achieved by the superposition of two optical filters: the first tunable resonator and the first interferometer, and tuning of the irradiance of the output light is achieved by the second tunable resonator and the second interferometer.

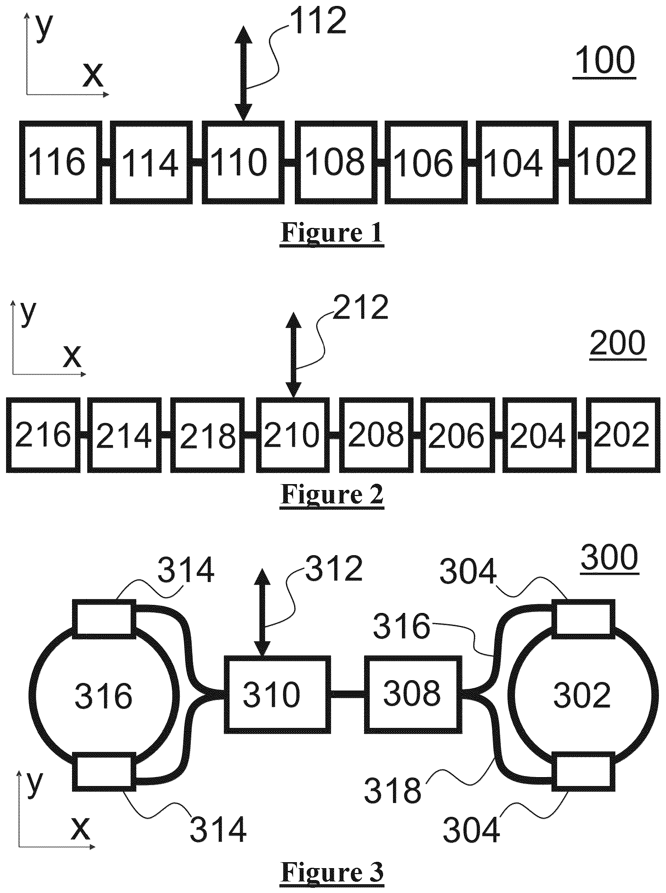

By way of a general introduction to the examples described herein, and with reference to Figures 1, which is not according to the invention as claimed, a linear tunable laser 100 comprises a first tunable resonator 102 comprising a waveguide; an interferometer 106 comprising a plurality of waveguides, at least one of the waveguides optically connected to the first tunable resonator; an optical amplifier 108 optically connected to the interferometer; a second tunable resonator 116 comprising a waveguide optically connected to the optical amplifier; and a power splitter 110 for the output of light 112 from the linear tunable laser. The linear tunable laser is configured for the output of light 112. In some examples an optical connection between the first tunable resonator 102 and the interferometer comprises a power splitter 104. In some examples an optical connection between the second tunable resonator 116 and the optical amplifier 108 comprises a power splitter 114. Some such examples are illustrated by Figure 1, and corresponding reference numerals are given earlier in this paragraph. In some examples, the linear tunable laser comprises a linear cavity, the linear cavity comprising the first tunable resonator, the interferometer, the optical amplifier, the second tunable resonator and the power splitter. A linear cavity e.g. at least one of reduces the footprint of the linear tunable laser compared to other cavity configurations such as a ring cavity or achieves more efficient filtering of the lasing mode. In some examples, the free spectral range of the first tunable resonator is different to the free spectral range of the second tunable resonator, in other examples, the free spectral range of the first tunable resonator is the same as the free spectral range of the second tunable resonator. In some examples, the linear tunable laser comprises at least one of an optical input; or an optical output. In some examples, the power splitter is a first power splitter and the linear tunable laser comprises a second power splitter for coupling light into the linear tunable laser.

In some examples, by utilising wavelength dependant interference, the interferometer is configured as a spectral filter and has the effect of suppressing undesired wavelengths of light. In some examples, the interferometer is modulated to allow the tuning of the wavelength of light output from the linear tunable laser. In some examples, at least one of the first tunable resonator or the second tunable resonator is configured as a spectral filter and has the effect of suppressing undesired wavelengths of light. In some examples, spectral filtering of the output light is desirable for applications, e.g. optical communications. This can reduce the need for a further optical component for wavelength tuning, which e.g. simplifies manufacture of a device comprising the linear tunable laser, reduces the footprint of and/or reduces the cost of producing a device comprising the laser.

In some examples, by utilising constructive interference or destructive interference, at least one of the interferometer, the first tunable resonator or the second tunable resonator is configured as an intensity modulator and allows modulation of the irradiance of light output from the linear tunable laser. Output intensity modulation is desirable for applications, e.g. optical coherence tomography or LIDAR. This can reduce the need for a further optical component for output irradiance tuning, which e.g. simplifies manufacture of a device comprising the linear tunable laser, reduces the footprint of and/or reduces the cost of producing a device comprising the laser.

A laser emits light produced by optical amplification. In some examples, light emitted from a laser is spatially coherent and temporally coherent.

A tunable resonator is for the formation of standing waves of light due to interference. In some examples a tunable resonator comprises a plurality of mirrors and separated by a distance such that a standing wave occurs when light is injected into the resonator. In some examples a resonator comprises a ring along the circumference of which light propagates, the circumference of the ring such that a standing wave occurs when light is injected into the resonator. Other tunable resonators are envisaged such as a plane parallel resonator, a concentric resonator, a confocal resonator, a disc resonator, a toroidal resonator, or a hemispherical resonator. A tunable resonator is tuned by tuning the optical path length of the resonator, which in turn tunes the wavelength of the standing wave formed in the resonator. In some examples, tuning of the wavelength of the standing wave is achieved by changing the length, circumference and/or refractive index of the tunable resonator. The refractive index of the tunable resonator is e.g. modulated by an electro-refractive modulator. In some examples tuning is achieved by thermal modulation or carrier injection.

An optical amplifier amplifies the intensity of an optical signal. In some examples, optical amplification is achieved by at least one of stimulated emission or emission due to electron-hole recombination. The wavelength of light amplified by the optical amplifier is e.g. between 10 nanometres and 1 millimetre. Examples of optical amplifiers are: solid-state amplifiers, dopedfibre amplifiers, semiconductor amplifiers, Raman amplifiers, or parametric amplifiers. In some examples, a semiconductor amplifier comprises Indium Gallium Arsenide Phosphide (InGaAsP) or Aluminium Indium Gallium Arsenide (AlInGaAs). Other optical amplifiers are envisaged. A power splitter has at least one light input and splits the light into a plurality of light outputs. In some examples a power splitter is a multimode interferometer (MMI), in other examples, a power splitter is a beam splitter, a partial mirror, a directional coupler, or a prism, other power splitters are envisaged. In some examples the splitting ratio between the optical outputs of the power splitter is 1: 1, other ratios are envisaged, e.g. between 1:100 and 100:1.

An interferometer uses interference between a plurality of light beams when the light beams are combined. A phase difference between the light beams produces constructive interference or destructive interference. In some examples the interferometer is a Mach-Zehnder interferometer, such as an asymmetric Mach-Zehnder interferometer. Other example interferometers are a Fizeau interferometer, a Fabry Perot interferometer, a Michelson interferometer, or a Lyot interferometer, other interferometers are envisaged. In some examples, an interferometer comprises an electro-refractive modulator. In some such examples, the electro-refractive modulator is configured to modulate the phase difference between the light beams when they interfere.

A waveguide is for guiding light. Light propagates within a waveguide and is confined within a waveguide due to reflection at the boundaries of the waveguide. A waveguide usually has a refractive index higher than the refractive index of material in contact with the waveguide at the boundaries at which confinement of light is desired. For example, due to this refractive index difference at the boundaries at which confinement of light is desired, total internal reflection takes place when the angle of incidence at these boundaries of the waveguide is greater than the critical angle. In this manner, a waveguide guides the propagation of light. For a particular optical mode to propagate in the waveguide, it is desired that light reflected at the boundaries of the waveguide fulfils the conditions for constructive interference. In some examples, the waveguides is at least one of: an etched ridge waveguide, vertical p-i-n junction or an electro-refractive modulator.

An optical filter transmits or reflects a first wavelength band of a light spectrum with greater irradiance than a second wavelength band of a light spectrum. An optical filter can be a periodic filter, a bandpass filter, a high-pass filter, or a low-pass filter, other filters are envisaged.

An optical connection is achieved in different ways in different examples. In some examples optical connections are achieved with waveguides; however, in other examples, other connections are envisaged, such as free-space propagation, and optical fibre connections. In some examples a tapered waveguide connects components that require different electrical and/or optical properties. In some examples herein, at least one of the optical connections are an optical coupling.

In some examples, the light comprises infrared radiation; in some such examples, the wavelength of the light is tunable between 1530 nanometres and 1565 nanometres. In some examples, such wavelengths are used for telecommunication applications.

A PIC integrates a plurality of photonic functions, for example a laser or a photodiode, other photonic functions are envisaged. In some examples, a PIC is configured for use with at least one of ultraviolet light, visible light, or infrared light. Optical radiation e.g. includes at least one of ultraviolet light, visible light, or infrared light. In some examples, a PIC comprises an electrical circuit. PICs are used for communications devices, biomedical devices and photonic computing, other applications are envisaged.

In examples, such as those of Figure 1, which is not according to the invention as claimed, the linear tunable laser 100 comprises a first tunable resonator 102, a MMI 104, an interferometer 106, an optical amplifier 108, a power splitter 110, an output and/or input of light 112, a MMI 114, and a second tunable resonator 116. Optical connections are indicated by the lines between boxes.

In examples, such as those of Figure 2, the interferometer 206 is a first interferometer, and the linear tunable laser comprises: a second interferometer 218 comprising a plurality of waveguides, at least one of the waveguides optically connected to the optical amplifier 208 and at least one of the waveguides optically connected to the second tunable resonator 216. Features of these examples are similar to features described above, and will be referred to using the same reference numeral incremented by 200 instead of 100; corresponding descriptions for such features apply here also.

In examples, such as those of Figure 3, the first tunable resonator 302 is a tunable ring resonator optically connected by two MMIs 304 to a Mach-Zehnder interferometer comprising two waveguides 316 and 318. In some examples, the Mach-Zehnder interferometer is asymmetric, in other examples, the Mach-Zehnder interferometer is symmetric. The second tunable resonator is optically connected to the power splitter by two MMIs 314. In some examples, at least one of the first tunable ring resonator or the second ring resonator comprises a waveguide which forms a ring. In some such examples the waveguide is an electro-refractive modulator. In some examples, the radius of the first tunable resonator is different as the radius of the second tunable resonator, which e.g. allows mode selection; in other examples the radius of the first tuneable ring resonator is the same as the radius of the second ring resonator. Features of these examples are similar to features described above, and will be referred to using the same reference numeral incremented by 300 instead of 100 or 200; corresponding descriptions for such features apply here also.

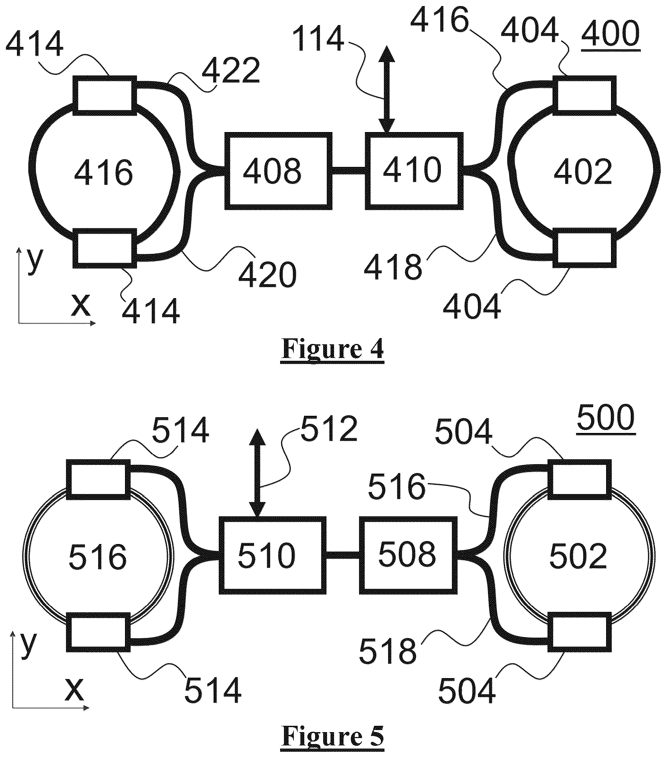

In examples, such as those of Figure 4, the second tunable resonator 416 is connected by two MMIs 414 to a Mach-Zehnder interferometer comprising two waveguides 420 and 422. In some such examples at least one of the waveguides of the Mach Zehnder interferometer is an electro-refractive modulator. In some examples, the Mach-Zehnder interferometer is asymmetric, in other examples, the Mach-Zehnder interferometer is symmetric. In examples of Figure 4, the waveguides of the first tunable resonator 402 and the second tunable resonator 416 are curved to form a tunable ring resonator but are not circular. In the invention according to the claims, the first tunable resonator and the first interferometer are configured for tuning the irradiance of light output from the linear tunable laser. In the invention according to the claims, the second tunable resonator and the second interferometer are configured for tuning the wavelength of light output from the linear tunable laser. Features of these examples are similar to features described above, and will be referred to using the same reference numeral incremented by 400 instead of 100 200, or 300; corresponding descriptions for such features apply here also.

In examples, such as those of Figure 5, the optical amplifier is a first optical amplifier and the waveguides of the first tunable resonator 502 and the second tunable resonator 516 comprise a second optical amplifier and a third optical amplifier respectively. In some examples this increases the irradiance of the output of the linear tunable laser 500 without needing to increase the size or footprint of the linear tunable laser. Features of these examples are similar to features described above, and will be referred to using the same reference numeral incremented by 500 instead of 100 200, 300 or 400; corresponding descriptions for such features apply here also.

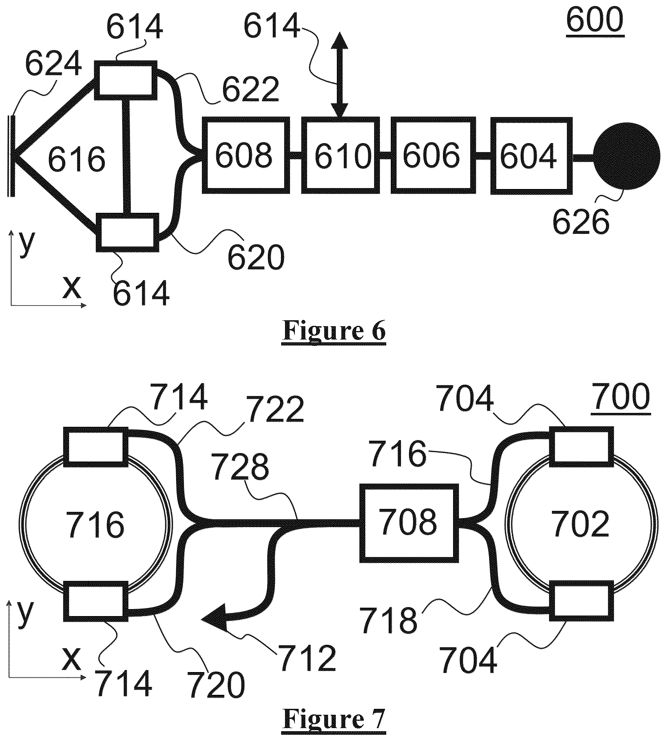

In examples, such as those of Figure 6, the first tunable resonator is a disc resonator 626 and the second tunable resonator comprises a movable mirror 624. Features of these examples are similar to features described above, and will be referred to using the same reference numeral incremented by 600 instead of 100, 200, 300, 400 or 500; corresponding descriptions for such features apply here also.

In examples, such as those of Figure 7, the power splitter is a directional coupler 728 formed by an output waveguide 712 being optically connected to the linear tunable laser at the connection between the optical amplifier 708 and the second interferometer 720 and 722. Features of these examples are similar to features described above, and will be referred to using the same reference numeral incremented by 700 instead of 100, 200, 300, 400, 500 or 600; corresponding descriptions for such features apply here also.

Some examples are configured for use in, or integration into, a generic photonic platform, e.g. an Indium Phosphide (InP) platform. In some examples integration into a generic photonic platform simplifies combination of the linear tunable laser with one or more components of the PIC which e.g. allows simpler, cheaper and/or quicker fabrication of the PIC.

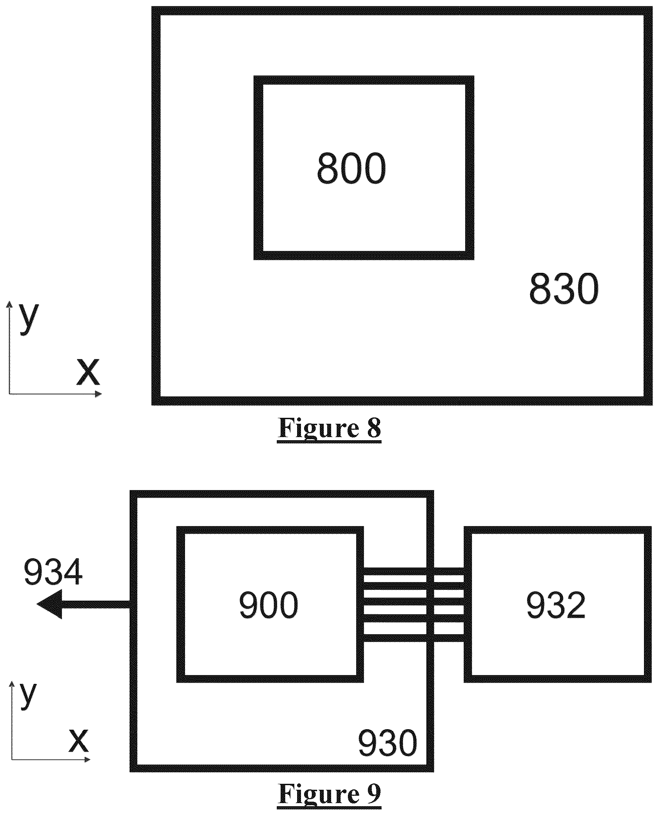

In examples, such as those of Figure 8, the linear tunable laser 800 is on a substrate 830, and the substrate is a monolith for a PIC. In other examples, the substrate is not a monolith for a PIC. In some examples, the linear tunable laser is integrated into a PIC.

In examples, such as those of Figure 9, a photonic device comprises a PIC 930, the PIC comprising the previously described tunable linear laser 900, an output for light 934, and an electrical controller 932. In some examples, the controller 932 is configured to tune at least one of the peak wavelength of light output from the linear tunable laser, or the irradiance of the peak wavelength of light output from the linear tunable laser. In some examples, the PIC comprises electrical circuitry which allows external control of components of the PIC by appropriate electrical connections to electrodes or other electrical contacts on the PIC.

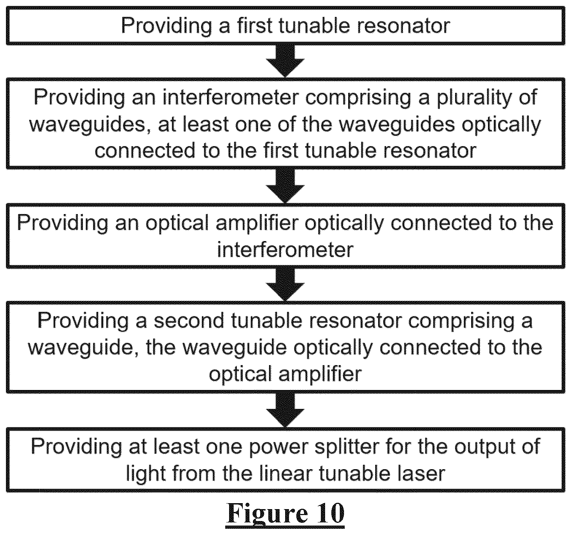

Figure 10 schematically illustrates a method of manufacturing a linear tunable laser in accordance with examples described previously, comprising: providing a first tunable resonator; providing an interferometer comprising a plurality of waveguides, at least one of the waveguides optically connected to the first tunable resonator; providing an optical amplifier optically connected to the interferometer; providing a second tunable resonator comprising a waveguide, the waveguide optically connected to the optical amplifier; and providing at least one power splitter for the output of light from the linear tunable laser. As the skilled person will appreciate, one or more of the components of the linear tunable laser can be provided by forming them during a manufacture process, using known techniques such as: metalorganic vapourphase epitaxy (MOVPE), surface passivation, photolithography, ion implantation, etching, dry etching ion etching, wet etching, buffered oxide etching, plasma ashing, plasma etching, thermal treatment, annealing, thermal oxidation, chemical vapor deposition, atomic layer deposition, physical vapor deposition, molecular beam epitaxy, laser lift-off, electrochemical deposition, electroplating, or chemical-mechanical polishing. **In** some examples etching techniques are used to remove portions of material, as part of patterning, as the skilled person will appreciate.

The above examples are to be understood as illustrative examples of the invention. Further examples of the invention are envisaged. For example, at least one of the waveguides, optical amplifier, tunable resonators, interferometer, semiconductors or substrates, described herein comprise at least one of Indium Phosphide (InP), Gallium Arsenide (GaAs), Gallium Antimonide (GaSb), Gallium Nitride (GaN), Indium Gallium Arsenide (InGaAs), Indium Aluminium Arsenide (InAlAs), Indium Aluminium Gallium Arsenide (InAlGaAs), Indium Gallium Arsenide Phosphide (InGaAsP), Silicon (Si), Silicon Nitride (Si₃N₄), Silicon Oxide (SiO₂), or Lithium Niobate (LiNbO₃); however, other semiconductor, and photonic materials are envisaged.

Modifications not described above may be employed without departing from the scope of the accompanying claims.

## Claims

1. A linear tunable laser (200) comprising a linear optical cavity comprising:
a first tunable resonator (202) comprising a waveguide;
a first interferometer (206) comprising a plurality of waveguides, at least one of the waveguides optically connected to the first tunable resonator (202);
an optical amplifier (208) optically connected to the first interferometer (206);
a second tunable resonator (216) comprising a waveguide optically connected to the optical amplifier (208);
a second interferometer (218) comprising a plurality of waveguides, at least one of the waveguides optically connected to the optical amplifier (208) and at least one of the waveguides optically connected to the second tunable resonator (216); and
a power splitter (210) for outputting light from the linear tunable laser (200), wherein
- the second tunable resonator (216) and the second interferometer (218) are configured for tuning a wavelength of light for the power splitter (216) to output,
**characterized in that**,
the first tunable resonator (202) and the first interferometer (206) are configured for tuning an irradiance of a peak irradiance of light for the power splitter (210) to output.

2. The linear tunable laser (200) of any previous claim, wherein at least one of the waveguide of the first tunable resonator (202) or the waveguide of the second tunable resonator (216) is curved.

3. The linear tunable laser (200) of any previous claim, wherein at least one of the first tunable resonator (202) or the second tunable resonator (216) is respectively a tunable ring resonator, wherein optionally the radius of the first tunable ring resonator is different from the radius of the second tunable ring resonator.

4. The linear tunable laser (200) of any previous claim, wherein at least one of the first tunable resonator (202), the second tunable resonator (216), or the first interferometer (206) respectively comprises an electro-refractive modulator.

5. The linear tunable laser (200) of any previous claim, wherein the first interferometer (206) is at least one of: a Mach-Zehnder interferometer, or an asymmetric Mach-Zehnder interferometer.

6. The linear tunable laser (200) of any previous claim, wherein the optical amplifier (208) is a first optical amplifier and at least one of the first tunable resonator (202) or the second tunable resonator (216) respectively comprises a second optical amplifier.

7. The linear tunable laser (200) of any previous claim, wherein at least one optical connection or the power splitter (210) respectively comprises at least one of a multi-mode interferometer or a directional coupler.

8. The linear tunable laser (200) of any previous claim, wherein the free spectral range of the first tunable resonator (202) is different to the free spectral range of the second tunable resonator (216).

9. The linear tunable laser (200) of any previous claim, wherein at least one of: the first tunable resonator (202), the second tunable resonator (216), or the optical amplifier (208) comprises Indium phosphide (InP).

10. The linear tunable laser (200) of any previous claim, wherein the power splitter (210) is a first power splitter and the linear tunable laser (200) comprises a second power splitter for coupling light into the linear tunable laser (200).

11. The linear tunable laser (200) of any previous claim, wherein the linear tunable laser (200) is on a monolith for a photonic integrated circuit.

12. A photonic integrated circuit comprising the linear tunable laser (200) of any previous claim.

13. A device comprising the photonic integrated circuit of claim 12.

14. The device of claim 13, comprising a controller configured to tune at least one of the peak wavelength of light output from the linear tunable laser (200), or the irradiance of the peak wavelength of light output from the linear tunable laser (200).

15. A method of manufacturing the linear tunable laser (200) of any of claims 1 to 11, the method comprising:
providing the first tunable resonator (202);
providing the first interferometer (206) comprising the plurality of waveguides, at least one of the waveguides optically connected to the first tunable resonator (202);
providing the optical amplifier (208) optically connected to the first interferometer;
providing the second tunable resonator (216) comprising the waveguide optically connected to the optical amplifier (208);
providing the second interferometer (218) comprising the plurality of waveguides; and
providing the power splitter (210) for outputting light from the linear tunable laser (200).

## Patentansprüche

1. Linearer abstimmbarer Laser (200), umfassend einen linearen optischen Hohlraum, umfassend:
einen ersten abstimmbaren Resonator (202), umfassend einen Wellenleiter;
ein erstes Interferometer (206), umfassend eine Vielzahl von Wellenleitern, wobei mindestens einer der Wellenleiter optisch mit dem ersten abstimmbaren Resonator (202) verbunden ist;
einen optischen Verstärker (208), der optisch mit dem ersten Interferometer (206) verbunden ist;
einen zweiten abstimmbaren Resonator (216), umfassend einen Wellenleiter, der optisch mit dem optischen Verstärker (208) verbunden ist;
ein zweites Interferometer (218), umfassend eine Vielzahl von Wellenleitern, wobei mindestens einer der Wellenleiter optisch mit dem optischen Verstärker (208) verbunden ist und mindestens einer der Wellenleiter optisch mit dem zweiten abstimmbaren Resonator (216) verbunden ist; und
einen Leistungsteiler (210) zum Ausgeben von Licht aus dem linearen abstimmbaren Laser (200), wobei
- der zweite abstimmbare Resonator (216) und das zweite Interferometer (218) zum Abstimmen einer Lichtwellenlänge für das Ausgeben durch den Leistungsteiler (216) konfiguriert sind, **dadurch gekennzeichnet, dass** der erste abstimmbare Resonator (202) und das erste Interferometer (206) zum Abstimmen einer Bestrahlungsstärke einer Spitzenbestrahlungsstärke von Licht für die Ausgabe durch den Leistungsteiler (210) konfiguriert sind.

2. Linearer abstimmbarer Laser (200) nach einem der vorstehenden Ansprüche, wobei mindestens einer von dem Wellenleiter des ersten abstimmbaren Resonators (202) oder dem Wellenleiter des zweiten abstimmbaren Resonators (216) gekrümmt ist.

3. Linearer abstimmbarer Laser (200) nach einem der vorstehenden Ansprüche, wobei mindestens einer von dem ersten abstimmbaren Resonator (202) oder dem zweiten abstimmbaren Resonator (216) jeweils ein abstimmbarer Ringresonator ist, wobei sich der Radius des ersten abstimmbaren Ringresonators optional von dem Radius des zweiten abstimmbaren Ringresonators unterscheidet.

4. Linearer abstimmbarer Laser (200) nach einem der vorstehenden Ansprüche, wobei mindestens einer von dem ersten abstimmbaren Resonator (202), dem zweiten abstimmbaren Resonator (216) oder dem ersten Interferometer (206), jeweils einen elektrorefraktiven Modulator umfasst.

5. Linearer abstimmbarer Laser (200) nach einem der vorstehenden Ansprüche, wobei das erste Interferometer (206) mindestens eines der Folgenden ist: ein Mach-Zehnder-Interferometer oder ein asymmetrisches Mach-Zehnder-Interferometer.

6. Linearer abstimmbarer Laser (200) nach einem der vorstehenden Ansprüche, wobei der optische Verstärker (208) ein erster optischer Verstärker ist und mindestens einer von dem ersten abstimmbaren Resonator (202) oder dem zweiten abstimmbaren Resonator (216) jeweils einen zweiten optischen Verstärker umfasst.

7. Linearer abstimmbarer Laser (200) nach einem der vorstehenden Ansprüche, wobei mindestens eine optische Verbindung oder der Leistungsteiler (210) jeweils mindestens eines von einem Multimode-Interferometer oder einem Richtkoppler umfasst.

8. Linearer abstimmbarer Laser (200) nach einem der vorstehenden Ansprüche, wobei sich der freie Spektralbereich des ersten abstimmbaren Resonators (202) von dem freien Spektralbereich des zweiten abstimmbaren Resonators (216) unterscheidet.

9. Linearer abstimmbarer Laser (200) nach einem der vorstehenden Ansprüche, wobei mindestens einer von dem ersten abstimmbaren Resonator (202), dem zweiten abstimmbaren Resonator (216) oder dem optischen Verstärker (208) Indiumphosphid (InP) umfasst.

10. Linearer abstimmbarer Laser (200) nach einem der vorstehenden Ansprüche, wobei der Leistungsteiler (210) ein erster Leistungsteiler ist und der lineare abstimmbare Laser (200) einen zweiten Leistungsteiler zum Einkoppeln von Licht in den linearen abstimmbaren Laser (200) umfasst.

11. Linearer abstimmbarer Laser (200) nach einem der vorstehenden Ansprüche, wobei sich der lineare abstimmbare Laser (200) auf einem Monolithen für eine photonische integrierte Schaltung befindet.

12. Photonische integrierte Schaltung, umfassend den linearen abstimmbaren Laser (200) nach einem der vorstehenden Ansprüche.

13. Vorrichtung, umfassend die photonische integrierte Schaltung nach Anspruch 12.

14. Vorrichtung nach Anspruch 13, umfassend einen Controller, der konfiguriert ist, um mindestens eines von der Spitzenwellenlänge des von dem linearen abstimmbaren Laser (200) ausgegebenen Lichts oder die Bestrahlungsstärke der Spitzenwellenlänge des von dem linearen abstimmbaren Laser (200) ausgegebenen Lichts abzustimmen.

15. Verfahren zum Herstellen des linearen abstimmbaren Lasers (200) nach einem der Ansprüche 1 bis 11, wobei das Verfahren umfasst:
Bereitstellen des ersten abstimmbaren Resonators (202);
Bereitstellen des ersten Interferometers (206), umfassend die Vielzahl von Wellenleitern, wobei mindestens einer der Wellenleiter optisch mit dem ersten abstimmbaren Resonator (202) verbunden ist;
Bereitstellen des optischen Verstärkers (208), der optisch mit dem ersten Interferometer verbunden ist;
Bereitstellen des zweiten abstimmbaren Resonators (216), umfassend den Wellenleiter, der optisch mit dem optischen Verstärker (208) verbunden ist;
Bereitstellen des zweiten Interferometers (218), umfassend die Vielzahl von Wellenleitern; und
Bereitstellen des Leistungsteilers (210) zum Ausgeben von Licht aus dem linearen abstimmbaren Laser (200).

## Revendications

1. Laser linéaire accordable (200) comprenant une cavité optique linéaire comprenant :
un premier résonateur accordable (202) comprenant un guide d'ondes ;
un premier interféromètre (206) comprenant une pluralité de guides d'ondes, au moins un des guides d'ondes étant optiquement connecté au premier résonateur accordable (202) ;
un amplificateur optique (208) relié optiquement au premier interféromètre (206) ;
un second résonateur accordable (216) comprenant un guide d'ondes optiquement connecté à l'amplificateur optique (208) ;
un second interféromètre (218) comprenant une pluralité de guides d'ondes, au moins un des guides d'ondes étant optiquement connecté à l'amplificateur optique (208) et au moins un des guides d'ondes étant optiquement connecté au second résonateur accordable (216) ; et
un séparateur de puissance (210) pour émettre de la lumière à partir du laser accordable linéaire (200), dans lequel
- le second résonateur accordable (216) et le second interféromètre (218) sont configurés pour accorder une longueur d'onde de la lumière que le séparateur de puissance (216) doit émettre, **caractérisé en ce que** le premier résonateur accordable (202) et le premier interféromètre (206) sont configurés pour accorder une irradiance d'un pic d'irradiance de la lumière que le séparateur de puissance (210) doit émettre.

2. Laser linéaire accordable (200) selon l'une quelconque des revendications précédentes, dans lequel au moins l'un des guides d'ondes du premier résonateur accordable (202) ou le guide d'ondes du second résonateur accordable (216) est incurvé.

3. Laser linéaire accordable (200) selon l'une quelconque des revendications précédentes, dans lequel au moins l'un du premier résonateur accordable (202) ou du second résonateur accordable (216) est respectivement un résonateur en anneau accordable, dans lequel le rayon du premier résonateur en anneau accordable est différent du rayon du second résonateur en anneau accordable.

4. Laser linéaire accordable (200) selon l'une quelconque des revendications précédentes, dans lequel au moins l'un du premier résonateur accordable (202), du second résonateur accordable (216) ou du premier interféromètre (206) respectivement comprend un modulateur électro-réfractif.

5. Laser linéaire accordable (200) selon l'une quelconque des revendications précédentes, dans lequel le premier interféromètre (206) est au moins l'un parmi : un interféromètre de Mach-Zehnder ou un interféromètre de Mach-Zehnder asymétrique.

6. Laser linéaire accordable (200) selon l'une quelconque des revendications précédentes, dans lequel l'amplificateur optique (208) est un premier amplificateur optique et au moins l'un du premier résonateur accordable (202) ou du second résonateur accordable (216) respectivement comprend un second amplificateur optique.

7. Laser linéaire accordable (200) selon l'une quelconque des revendications précédentes, dans lequel au moins une connexion optique ou le séparateur de puissance (210) comprend respectivement au moins un interféromètre multimode ou un coupleur directionnel.

8. Laser linéaire accordable (200) selon l'une quelconque des revendications précédentes, dans lequel la gamme spectrale libre du premier résonateur accordable (202) est différente de la gamme spectrale libre du second résonateur accordable (216).

9. Laser linéaire accordable (200) selon l'une quelconque des revendications précédentes, dans lequel au moins l'un parmi : le premier résonateur accordable (202), le second résonateur accordable (216) ou l'amplificateur optique (208) comprend du phosphure d'indium (InP).

10. Laser linéaire accordable (200) selon l'une quelconque des revendications précédentes, dans lequel le séparateur de puissance (210) est un premier séparateur de puissance et le laser linéaire accordable (200) comprend un second séparateur de puissance pour coupler la lumière dans le laser linéaire accordable (200).

11. Laser linéaire accordable (200) selon l'une quelconque des revendications précédentes, dans lequel le laser linéaire accordable (200) est sur un monolithe pour un circuit intégré photonique.

12. Circuit intégré photonique comprenant le laser linéaire accordable (200) selon l'une quelconque des revendications précédentes.

13. Dispositif comprenant le circuit intégré photonique selon la revendication 12.

14. Dispositif selon la revendication 13, comprenant un dispositif de commande configuré pour régler au moins l'un parmi : la longueur d'onde maximale de la lumière émise par le laser linéaire accordable (200), ou l'irradiance de la longueur d'onde maximale de la lumière émise par le laser linéaire accordable (200).

15. Procédé de fabrication du laser accordable linéaire (200) selon l'une quelconque des revendications 1 à 11, le procédé comprenant :
la fourniture du premier résonateur accordable (202) ;
la fourniture du premier interféromètre (206) comprenant la pluralité de guides d'ondes, au moins l'un des guides d'ondes étant optiquement connecté au premier résonateur accordable (202) ;
la fourniture de l'amplificateur optique (208) optiquement connecté au premier interféromètre ;
la fourniture du second résonateur accordable (216) comprenant le guide d'ondes optiquement connecté à l'amplificateur optique (208) ;
la fourniture du second interféromètre (218) comprenant la pluralité de guides d'ondes ; et
la fourniture du séparateur de puissance (210) destiné à émettre de la lumière à partir du laser accordable linéaire (200).
